# NEUE EUROPÄISCHE PATENTSCHRIFT

(11) **EP 3 395 621 B2**
(45) Veröffentlichungstag und Bekanntmachung des Hinweises auf die Entscheidung über den Einspruch: **18.12.2024**
(45) Hinweis auf die Patenterteilung: 10.06.2020
(21) Anmeldenummer: 18167030.8
(22) Anmeldetag: 12.04.2018
(51) Int. Cl.: B60R 25/20, G07C 9/00, E05F 15/70

(54) **STEUERUNGSVERFAHREN UND STEUERUNGSSYSTEM FÜR EIN FAHRZEUGSCHLIESSELEMENT**
CONTROL METHOD AND CONTROL SYSTEM FOR A VEHICLE LOCKING ELEMENT
PROCÉDÉ DE COMMANDE ET SYSTÈME DE COMMANDE POUR UN ÉLÉMENT DE FERMETURE DE VÉHICULE

(30) Priorität: 28.04.2017 DE 102017207279
(43) Veröffentlichungstag der Anmeldung: 31.10.2018
(73) Patentinhaber: Brose Fahrzeugteile SE & Co. Kommanditgesellschaft, Bamberg, 96052 Bamberg (DE)
(72) Erfinder: GOLDMANN, Thomas, 95445 Bayreuth (DE); GUNREBEN, Andre, 96103 Hallstadt (DE)
(74) Vertreter: Maikowski & Ninnemann Patentanwälte Partnerschaft mbB

(56) Entgegenhaltungen:
- EP-B1- 2 821 296
- WO-A1-2011/092341
- WO-A1-2014/032988
- WO-A1-2015/113554
- DE-A1- 102004 035 585
- DE-A1- 102010 018 164
- DE-A1- 102010 037 577
- DE-A1- 102010 060 364
- DE-A1- 102014 101 201
- DE-A1- 102015 009 749
- US-A1- 2016 318 480

## Beschreibung

Die vorliegende Erfindung betrifft ein Verfahren zur Steuerung einer Verstellbewegung eines fremdkraftbetätigt verstellbaren Fahrzeugschließelements, wie z.B. einer Fahrzeugseitentür oder einer Fahrzeugheccklappe, sowie ein Steuerungssystem.

Zum Auslösen einer Verstellbewegung eines fremdkraftbetätigt, insbesondere motorisch verstellbaren Fahrzeugschließelements ist es bekannt, berührungslos Bedienereignisse mittels mindestens eines an dem Fahrzeug vorgesehenen Sensorelements einer Sensoreinrichtung zu erkennen, die auf eine Bewegung eines (autorisierten) Benutzers zurückgehen. Hierfür umfasst ein Sensorelement beispielsweise einen Näherungssensor, über den eine Kick-Bewegung einer Person erfasst und dies gegebenenfalls als Bedienereignis bewertet werden kann, um eine motorische Verstellung des Fahrzeugschließelements zu veranlassen.

Für die Detektion eines Bedienereignisses in Form einer Kick-Bewegung, die zum Beispiel im Bereich eines Stoßfängers des Fahrzeugs ausgeführt wird, wird ein Verlauf von durch die Sensoreinrichtung in einem Detektionszeitintervall (kontinuierlich oder diskret) erfassten Messwerten ausgewertet. Lässt sich anhand einer Folge von mehreren Messwerten durch Vergleich mit hinterlegten Referenz- und/oder Schwellwerten dann über eine Auswertelogik einer elektronischen Steuereinrichtung feststellen, dass die Person die als Bedienereignis zu bewertende Bewegung im Detektionsbereich ausgeführt hat, erfolgt die Verstellung des Fahrzeugschließelements.

Der eigentlichen Verstellung des Fahrzeugschließelements ist hierbei üblicherweise die Erzeugung und das Senden wenigstens eines Triggersignals vorangestellt, dass mindestens eine der Verstellung des Fahrzeugschließelements vorgelagerte Operation triggert. So kann über ein Triggersignal beispielsweise nach der Detektion eines Bedienereignisses die Durchführung eines Authentifizierungsprozesses ausgelöst werden, bei dem das Vorliegen eines gültigen Identifikationsmittels in einer Umgebung des Fahrzeugs überprüft wird. Nur wenn sowohl ein Bedienereignis detektiert wurde als auch ein gültiges Identifikationsmittel in der Umgebung des Fahrzeugs vorliegt und damit beide Bedingungen kumulativ erfüllt sind, wird eine Verstellung des Fahrzeugschließelements ausgelöst. Für das Verstellen des Fahrzeugschließelements wird dann ein (weiteres) Triggersignal an einen Antrieb gesendet, um diesen zu aktivieren. Mittels dieses weiteren oder mittels eines vorherigen Triggersignal kann ferner auch ein das Fahrzeugschließelement in einer geschlossenen Position verriegelndes Schloss betätigt werden.

Bei bisher in der Praxis umgesetzten Steuerungsverfahren werden die jeweiligen notwendigen Triggersignale für die der eigentlichen Verstellung des Fahrzeugschließelements vorgelagerten Operationen, ohne deren Ausführung eine Verstellung des Fahrzeugschließelements unterbleibt, nacheinander und erst nach der Auswertung, ob ein Bedienereignis vorliegt, erzeugt und gesendet. Dementsprechend vergeht nach der durch die Person ausgeführten Bewegungen eine gewisse Zeit, bis tatsächlich eine Verstellung des Fahrzeugschließelements erfolgt oder bis über entsprechende vorgelagerte Operationen dem Benutzer die Detektion eines gültigen Bedienereignisses signalisiert wird. Nicht selten führt daher eine Person die Bewegung in dem Direktionsbereich bereits ein zweites Mal aus, in der Annahme das die erste Bewegung nicht erkannt wurde. Dies hat unter Umständen ein unerwünschtes Funktionsverhalten zur Folge und wirkt sich negativ auf den Bedienkomfort und die Nutzerzufriedenheit aus.

In der DE 10 2010 060 364 A1 ist zumindest bereits pauschal vorgeschlagen, dass ein Authentifizierungsprozess vor, während oder nach der Definition eines Bedienereignisses erfolgen kann, wobei letztlich die Verstellung des Fahrzeugschließelements nur dann erfolgt, falls sowohl eine positive Authentifizierung als auch eine positive Detektion eines Bedienereignisses vorliegen. Zu welchem Zeitpunkt, auf welcher Basis und insbesondere mittels welchen Signals der Authentifizierungsprozess getriggert wird, finden sich in der DE 10 2010 060 364 A1 keine Angaben.

Der Erfindung liegt vor diesem Hintergrund die Aufgabe zugrunde, ein Steuerungsverfahren sowie ein Steuerungssystem für die Verstellung eines fremdkraftbetätigt verstellbaren Fahrzeugschließelements mit Blick auf den Bedienkomfort zu verbessern.

Diese Aufgabe wird sowohl mit einem Verfahren nach Anspruch 1 als auch einem Verfahren nach Anspruch 5 und einem Steuerungssystem nach Anspruch 12 gelöst.

Bei einem erfindungsgemäßen Verfahren wird mittels einer Sensoreinrichtung als Bedienereignis berührungslos detektiert, ob eine Person mit einem Körperteil eine bestimmte Bewegung in einem Detektionsbereich ausführt, wobei zur Detektion des Bedienereignisses ein Verlauf von durch die Sensoreinrichtung in einem Detektionszeitintervall (kontinuierlich oder diskret) erfassten Messwerten ausgewertet wird. Ferner ist vorgesehen, dass wenigstens ein Triggersignal erzeugt und gesendet wird, dass mindestens eine der Verstellung des Fahrzeugschließelements vorgelagerte Operation getriggert, ohne deren Ausführung eine Verstellung des Fahrzeugschließelements unterbleibt. Eine solche vorgelagerte Operation umfasst dann z.B. einen Authentifizierungsprozess, die Entriegelung eines Schlosses für das Fahrzeugschließelement oder die Aktivierung eines Antriebs für das Verstellen des Fahrzeugschließelements.

Gemäß einem ersten Aspekt ist vorgesehen, dass mindestens ein für das Vorliegen eines Bedienereignisses erfasster Messwert genutzt wird, das Senden des Triggersignals auszulösen, bevor das Detektionszeitintervall verstrichen ist und bevor - zum Beispiel anhand mindestens eines weiteren Messwerts und angesichts hinterlegter Kriterien, insbesondere Referenz- und/oder Schwellenwerte - überhaupt der Verlauf der Messwerte dahingehend ausgewertet werden kann, ob ein Bedienereignis vorliegt. Das Senden des Triggersignals wird somit auf Basis mindestens eines Messwertes für eine Messgröße ausgelöst, die erst (nachfolgend) für die Auswertung herangezogen wird, ob ein Bedienereignis vorliegt oder nicht. Die Entscheidung, ob das Senden des Triggersignals begonnen werden soll, kann somit zum Beispiel bereits auf Basis eines Teilbereiches des für das Vorliegen eines Bedienereignisses erst später vervollständigten, repräsentativen Verlaufs von Messwerten erfolgen und damit bevor klar ist, ob überhaupt ein (zulässiges) Bedienereignis vorliegt oder nicht. Es wird damit zunächst grundsätzlich in Kauf genommen, dass das Triggersignal zumindest teilweise bereits gesendet ist oder sogar die damit zu triggernde Operation bereits begonnen wird, obwohl unter Umständen am Ende des Detektionszeitintervalls kein Bedienereignis detektiert wird. Wird aber ein Bedienereignis detektiert, ist die wenigstens eine mit dem mindestens einen Triggersignal getriggerte Operation früher ausgelöst oder auslösbar als in bisher üblichen Steuerungsverfahren, bei denen das Senden des Triggersignals erst am Ende des Detektionszeitintervalls gestartet werden kann. Ferner kann aufgrund der Nutzung eines Messwertes, der ohnehin für die Auswertung, ob ein Bedienereignis vorliegt, gebraucht wird, eine Erfassung einer zusätzlichen Messgröße für den Beginn des Sendens des Triggersignals entfallen.

Der auszuwertende Verlauf von durch die Sensoreinrichtung in einem Detektionszeitintervall erfassten Messwerte wird somit beispielsweise in mehrere (mindestens zwei) Teilfunktionen oder Teilbereiche zerlegt, wobei bereits auf Basis einer ersten Teilfunktion respektive eines ersten Teilbereiches über den Beginn des Sendens des Triggersignals entschieden wird, gleichwohl erst mittels der wenigstens einen weiteren, zweiten Teilfunktion respektive des weiteren, zweiten Teilbereichs erst darüber entschieden werden kann, ob tatsächlich ein zulässiges Bedienereignis vorliegt oder nicht.

Gemäß dem ersten Aspekt wird mittels des zu sendenden Triggersignals ein Authentifizierungsprozess ausgelöst, bei dem das Vorliegen eines gültigen Identifikationsmittels in einer Umgebung des Fahrzeugs überprüft wird. Ein Triggersignal für die Auslösung des Authentifizierungsprozesses wird somit bereits zu einem Zeitpunkt innerhalb des Direktionszeitintervalls gesendet, an dem anhand der hinterlegten Kriterien mittels einer Auswertelogik noch keine Entscheidung darüber getroffen werden kann, ob tatsächlich von einer Person mit einem Körperteil eine als Bedienereignis zu bewertende Bewegung in einem Selektionsbereich ausgeführt wird oder nicht.

In einer Ausführungsvariante ist das Senden des Triggersignals für den Start des Authentifizierungsprozesses auch zu einem Zeitpunkt abgeschlossen, bevor das Detektionszeitintervall verstrichen ist. Der Authentifizierungsprozess wird hier somit nicht nur auf Basis des mindestens einen erfassten Messwertes gestartet, bevor ausgewertet wurde, ob ein Bedienereignis vorliegt oder nicht. Vielmehr kann auch der mit dem Triggersignal ausgelöste Authentifizierungsprozess bereits zu einem Zeitpunkt abgeschlossen sein, bevor das Detektionszeitintervall abgelaufen ist und bevor eine ausreichende Anzahl Messwerte erfasst wurde, um auszuwerten, ob ein Bedienereignis vorliegt oder nicht. Die Dauer und damit Signallänge eines Triggersignals und die Dauer und damit Länge des Authentifizierungsprozesses sind hier folglich so aufeinander und auf das Detektionszeitintervall abgestimmt, dass der Abschluss des einmal zulässig gestarteten Authentifizierungsprozesses in jedem Fall noch innerhalb des Detektionszeitintervalls abgeschlossen ist. Damit ist am Ende des Detektionszeitintervalls für die Prüfung, ob ein Bedienereignis vorliegt, bereits überprüft, ob ein Identifikationsmittel in der Umgebung des Fahrzeugs vorliegt. Wurde tatsächlich ein zulässiges Bedienereignis detektiert, kann somit am Ende des Detektionszeitintervalls auch gleich die Verstellung des Fahrzeugschließelements ausgelöst werden, da der Authentifizierungsprozess und damit die Suche nach einem gültigen Identifikationsmittel und damit nach einem authentifizierten Nutzer bereits parallel durchgeführt wurde. Wurde kein gültiges Identifikationsmittel in Reichweite ermittelt, unterbleibt die Verstellung des Fahrzeugschließelements und das Steuerungsverfahren kann unmittelbar nach der Auswertung, ob ein Bedienereignis vorliegt oder nicht, gestoppt werden.

In einer alternativen Ausführungsvariante ist vorgesehen, dass das Senden des Triggersignals, wenn ein Bedienereignis detektiert wurde, erst zu einem Zeitpunkt abgeschlossen wird, nachdem das Detektionszeitintervall verstrichen ist. Das Senden des den Authentifizierungsprozess auslösenden Triggersignals wird somit zwar innerhalb des Detektionszeitintervall auf Basis des mindestens einen erfassten Messwertes begonnen. Jedoch ist das Senden und damit die Übermittlung des Triggersignals zum Ende des Detektionszeitintervalls noch nicht abgeschlossen. Am Ende des Detektionszeitintervalls ist damit das Triggersignal noch unvollständig und die Authentifizierung wird noch nicht gestartet.

So ist in einer Ausführungsvariante in einer das Triggersignal empfangenden elektronischen Steuerung für den Start des Authentifizierungsprozesses hinterlegt, dass der Authentifizierungsprozess erst gestartet wird, wenn ein Triggersignal mit einer vorgegebenen Signallänge, zum Beispiel in Form eines codierten Signals mit High- und Low-Pegeln, in Form eines Pulses oder in Form einer Pulssequenz mit vordefinierter Signal-, Puls- oder Sequenzlänge, empfangen wird. In der vorgeschlagenen Ausführungsvariante wird nun das Senden des Triggersignals noch im Detektionszeitintervall gestartet, jedoch zu einem Zeitpunkt, an dem der zeitliche Abstand zum Ende des Detektionszeitintervalls derart gering ist, dass das Triggersignal zum Ende des Detektionszeitintervalls noch nicht vollständig gesendet sein kann. Zum Ende des Detektionszeitintervalls ist in dieser Variante lediglich ein Teil des zur Auslösung des Authentifizierungsprozesses notwendigen Triggersignals übertragen, sodass beim Ausbleiben einer Detektion eines (zulässigen) Bedienereignisses das Senden des Triggersignals nach dem Detektionszeitintervall abgebrochen werden kann und damit das bisher gesendete Triggersignal unvollständig bleibt. Die der Verstellung des Fahrzeugschließelements vorgelagerte Authentifizierung wird somit nicht ausgeführt (und damit auch nicht die Verstellung des Fahrzeugschließelements, die eine positive Authentifizierung und die Detektion eines Bedienereignisses kumulativ voraussetzt). Wird ein Bedienereignis detektiert, muss das Triggersignal nur noch weiter gesendet und damit auf die definierte Signallänge verlängert werden, um den Authentifizierungsprozess auszulösen. Da das Senden des nachfolgend vervollständigten Triggersignals bereits vor der Detektion eines Bedienereignisses begonnen wird, kann - im Vergleich zu einem erst nach Detektion eines Bedienereignis gestarteten Senden des Triggersignals - die Zeit verkürzt werden, die vom Beginn der durch den Nutzer ausgeführten Bewegung bis zum Abschluss der Authentifizierung und der Verstellung des Fahrzeugschließelements vergeht.

Unabhängig davon, ob das Senden des Triggersignals erst nach dem Ende des Detektionszeitintervalls (bei positiver Detektion eines Bedienereignisses) oder innerhalb des Detektionszeitintervalls abgeschlossen wird, liegt gemäß dem ersten Aspekt der Zeitpunkt, an dem das Senden des Triggersignals ausgelöst wird, zu einem Zeitpunkt innerhalb des Detektionszeitintervall, an dem ein in einer elektronischen Steuereinrichtung hinterlegtes Kriterium betreffend die Anzahl erfasster Messwerte erfüllt ist. Ein solches Kriterium kann beispielsweise das Überschreiten einer Mindestanzahl an Messwerten umfassen, die zur Verfügung stehen muss, um ein Bedienereignis mit einer definierten Wahrscheinlichkeit annehmen zu können. Der Beginn des Zeitpunktes, an dem das Senden des Triggersignals ausgelöst wird, kann somit zu einem Zeitpunkt innerhalb des Detektionszeitraumes liegen, an dem eine hinreichende (vorab definierte) Menge an Messwerten zur Verfügung steht, die ein Bedienereignis mit einer hinreichenden (vorab definierten) Wahrscheinlichkeit annehmen lässt. Beispielsweise liegt damit dieser Zeitpunkt in einer letzten Hälfte des Detektionszeitintervalls. In einer zweiten Hälfte des Detektionszeitintervalls kann dabei z.B. davon auszugehen sein, dass bereits eine aussagekräftige Tendenz für das Vorliegen eines Bedienereignisses auf Basis der Anzahl erfasster Messwerte möglich ist und damit eine Einschätzung mit einer hinreichenden Wahrscheinlichkeit (die ggf. vorab in einer elektronischen Steuereinrichtung hinterlegt wurde). In dem zuletzt genannten Fall erfolgt das Senden des Triggersignals z.B. dann stets erst, nachdem mehr als die Hälfte des Detektionszeitintervalls verstrichen ist, und insbesondere in einem letzten Drittel des Detektionszeitintervalls.

Das frühzeitige Senden wenigstens eines Teils eines Triggersignals, das nach der Detektion eines Bedienereignisses vervollständigt, insbesondere auf eine vordefinierte Signallänge verlängert wird, ist dabei offensichtlich unabhängig davon, auf welcher Basis und insbesondere welcher Messgröße und damit welchem Messwert das Senden des Triggersignals ausgelöst wird. Dementsprechend ist nach einem weiteren - mit dem ersten Aspekt grundsätzlich kombinierbaren - Aspekt ein Verfahren zur Steuerung einer Verstellbewegung eines fremdkraftbetätigt verstellbaren Fahrzeugschließelements vorgeschlagen, bei dem wenigstens ein Triggersignal mit einer definierten Signallänge erzeugt und gesendet wird, das mindestens eine der Verstellung des Fahrzeugschließelements vorgelagerte Operation triggert. Diese mindestens eine Operation kann insbesondere den vorstehend erläuterten Authentifizierungsprozess, die Ansteuerung eines Schlosses für die Entriegelung des Fahrzeugschließelements und/oder die Aktivierung eines Antriebs für das fremdkraftbetätigte Verstellen des Fahrzeugschließelements umfassen. Gemäß dem zweiten Aspekt ist hierbei vorgesehen, dass das Senden des Triggersignals zu einem Zeitpunkt in dem Detektionszeitintervall begonnen wird, sodass am Ende des Detektionszeitintervalls das Triggersignal die definierte Signallänge noch nicht erreicht hat, und das Triggersignal nur bei Detektion eines Bedienereignisses weiter bis zum Erreichen der definierten Signallänge gesendet und damit vervollständigt wird, ansonsten aber dessen Senden abgebrochen wird.

Gemäß einer Ausführungsvariante kann das Senden des Triggersignals abgebrochen werden, wenn kein Bedienereignis detektiert wurde, sodass das bisher übertragene Triggersignal unvollständig bleibt und die der Verstellung des Fahrzeugschließelements vorgelagerte Operation nicht getriggert wird. Es wird folglich beispielsweise kein Authentifizierungsprozess gestartet und/oder es erfolgt keine Aktivierung eines Antriebs für die Verstellung des Fahrzeugschließelements, ebenso wie natürlich die Verstellung des Fahrzeugschließelements selbst nicht erfolgt.

Gemäß dem zweiten Aspekt wird somit ein Triggersignal, insbesondere in Form eines Pulses, einer Pulssequenz oder einer kontinuierlichen Signalfolge (Letzere insbesondere als codiertes Signal mit High- und Low-Pegel), auf die volle Länge verlängert, wenn ein Bedienereignis detektiert wurde. Hierbei kann das vollständige Triggersignal bereits deutlich früher gesendet werden, als wenn das Senden erst mit Abschluss der Detektion eines Bedienereignisses erfolgt. Wird kein Bedienereignis detektiert, wird auf Basis des unvollständigen Triggersignals auch die der Verstellung des Fahrzeugschließelements vorgelagerte Operation nicht ausgeführt. Das nur teilweise Senden des (damit gen) Triggersignals bleibt hierbei vorzugsweise ohne Konsequenz und ist insbesondere für einen Nutzer nicht bemerkbar.

In einem Ausführungsbeispiel ist vor dem Ende des Detektionszeitintervalls mehr als die Hälfte des zum Triggern der der Verstellung des Fahrzeugschließelements vorgelagerten Operation bereits gesendet. Demgemäß ist in dieser Variante bereits mehr als die Hälfte des Triggersignals, insbesondere mehr als 70% des Triggersignals übertragen, bevor ein Bedienereignis detektierbar ist. Beispielsweise ist hierbei mehr als die Hälfte des zum Starten des Autorisierungsprozesses zu übertragenden Triggersignals bereits an eine Authentifizierungselektronik und/oder mehr als die Hälfte des für die Aktivierung des Schlosses und/oder Antriebs zu übertragenden Triggersignals an eine Steuerelektronik des Schlosses oder Antriebs übertragen, bevor detektiert wird, ob tatsächlich ein Bedienereignis vorliegt oder nicht.

Der Beginn des Sendens des Triggersignals kann grundsätzlich durch ein Über- oder Unterschreiten eines vorgegebenen Schwellwertes durch einen erfassten Messwert ausgelöst werden, bevor das Detektionsintervall verstrichen und ausgewertet ist, ob ein Bedienereignis vorliegt oder nicht.

Grundsätzlich kann für das Verstellen des Fahrzeugschließelements ein Antrieb mittels eines (weiteren) Triggersignals in Form eines Steuersignals aktivierbar sein, wobei das Senden dieses Steuersignals begonnen wird, nachdem das Detektionszeitintervall verstrichen und ausgewertet ist, ob ein Bedienereignis vorliegt. In einer hierauf basierenden ersten Ausführungsvariante wird beispielsweise mittels eines vor dem Ende des Detektionszeitintervalls teilweise oder vollständig gesendeten Triggersignals lediglich ein Authentifizierungsprozess gestartet. Liegt am Ende des Authentifizierungsprozesses eine positive Authentifizierung für das Vorliegen eines gültigen Identifikationsmittels in der Umgebung des Fahrzeugs vor, wird hierüber automatisch die nachfolgende Betätigung eines Schlosses und/oder die nachfolgende Aktivierung des Antriebs für das Verstellen des Fahrzeugschließelements mittels eines Steuersignals getriggert. In einer zweiten Ausführungsvariante wird beispielsweise der Authentifizierungsprozess von einer elektronischen Steuereinrichtung mittels eines ersten Triggersignals getriggert und separat hiervon die Aktivierung eines Antriebs von der derselben elektronischen Steuereinrichtung mittels eines weiteren, zweiten Triggersignals in Form des Steuersignals.

Zur Vermeidung eines fehlerhaften Sendens des Triggersignals kann grundsätzlich vorgesehen sein, dass die Erzeugung und der Beginn des Sendens des Triggersignals von mindestens einem zusätzlichen Kriterium abhängig sind. Ein solches zusätzliches Kriterium kann beispielsweise eine zeitliche Entwicklung aufeinanderfolgender erfasster Messwerte und/oder der Wert eines Maximum erfasster Messwerte sein. So kann beispielsweise das Senden des Triggersignals grundsätzlich davon abhängig sein, ob eine für das Vorliegen eines Bedienereignisses ausgewertete Messgröße mit erfassten Messwerten einen (ersten) Schwellenwert überschreitet. Für den Beginn des Sendens des Triggersignals wird dann jedoch noch zusätzlich ausgewertet, inwieweit aufeinanderfolgende Messwerte (vor oder nach dem Überschreiten des Schwellwertes) ansteigen oder abfallen und/oder ob der Verlauf der Messwerte ein (lokales) Maximum aufweist, dessen Wert einen Referenzwert nicht über- oder unterschreitet. Die als zusätzliches Kriterium für das Senden des Triggersignals ausgewählte zeitliche Entwicklung aufeinanderfolgend erfasster Messwerte und/oder der Wert eines Maximum erfasster Messwerte soll hierbei im Vergleich mit einer hinterlegten Referenz oder mehreren hinterlegten Referenzen eine Aussage darüber ermöglichen, ob tatsächlich das Vorliegen eines Bedienereignisses wahrscheinlich erscheint. Spricht das wenigstens eine zusätzlich ausgewertete Kriterium gegen das Vorliegen eines Bedienereignisses, ist auch das Senden eines Triggersignals obsolet, dass eine der Verstellung des Fahrzeugschließelements vorgelagerte Operation, insbesondere einen Authentifizierungsprozess, startet, der ohne das Vorliegen eines Bedienereignisses ohnehin nicht zur Verstellung des Fahrzeugschließelements führt.

Wie bereits eingangs erläutert, wird mittels der Sensoreinrichtung beispielsweise berührungslos eine durch eine Person, insbesondere im Bereich eines Stoßfängers des Fahrzeugs, ausgeführte Kick-Bewegung als Bedienereignis detektiert. Ein solches Bedienereignis soll dann vorzugsweise die Verstellung eines Fahrzeugschließelements in Form einer Heckklappe oder eines Kofferraumdeckels des Fahrzeugs auslösen.

Ein weiterer Aspekt der Erfindung ist ferner die Bereitstellung eines Steuerungssystems für eine Verstelleinrichtung zum fremdkraftbetätigten Verstellen eines Fahrzeugschließelements. Ein solches Steuerungssystem umfasst wenigstens eine Sensoreinrichtung, mittels der als Bedienereignis berührungslos detektierbar ist, dass eine Person mit einem Körperteil eine bestimmte Bewegung in einem Detektionsbereich ausgeführt hat. Ferner umfasst das Steuerungssystem eine elektronische Steuereinrichtung, mittels der
- ein Verlauf von durch die Sensoreinrichtung in einem Detektionszeitintervall (kontinuierlich oder diskret) erfassten Messwerten dahingehend auswertbar ist, ob ein Bedienereignis vorliegt,
- wenigstens ein Triggersignal definierter Signallänge erzeugt und gesendet werden kann, das mindestens eine der Verstellung des Fahrzeugschließelements vorgelagerte Operation triggert.

Erfindungsgemäß ist nun ferner vorgesehen, dass die elektronische Steuereinrichtung konfiguriert ist,
a) mindestens einen für das Vorliegen eines Bedienereignisses erfassten Messwert zu nutzen, das Senden eines Triggersignals für einen Authentifizierungsprozess, bei dem das Vorliegen eines gültigen Identifikationsmittels in einer Umgebung des Fahrzeugs überprüft wird, auszulösen, bevor das Detektionszeitintervall verstrichen ist und bevor der Verlauf der Messwerte dahingehend ausgewertet werden kann, ob ein Bedienereignis vorliegt (oder nicht), und/oder
b) zu einem Zeitpunkt in dem Detektionszeitintervall das Senden des Triggersignals zu beginnen, sodass am Ende des Detektionszeitintervalls das Triggersignal die definierte Signallänge noch nicht erreicht hat und das Triggersignal nur bei Detektion eines Bedienereignisses weiter bis zum Erreichen der definierten Signallänge gesendet, ansonsten aber dessen Senden abgebrochen wird.

Das vorgeschlagene Steuerungssystem kann sich insbesondere zur Durchführung eines erfindungsgemäßen Verfahrens eignen. Dementsprechend gelten vorstehend und nachstehend erläuterte Merkmale eines Ausführungsbeispiels für ein erfindungsgemäßes Verfahren (gemäß dem ersten oder zweiten Aspekt) auch für Ausführungsbeispiele eines erfindungsgemäßen Steuerungssystems und umgekehrt.

Die beigefügten Figuren veranschaulichen exemplarisch mögliche Ausführungsvarianten der vorgeschlagenen Lösung.

Hierbei zeigen:

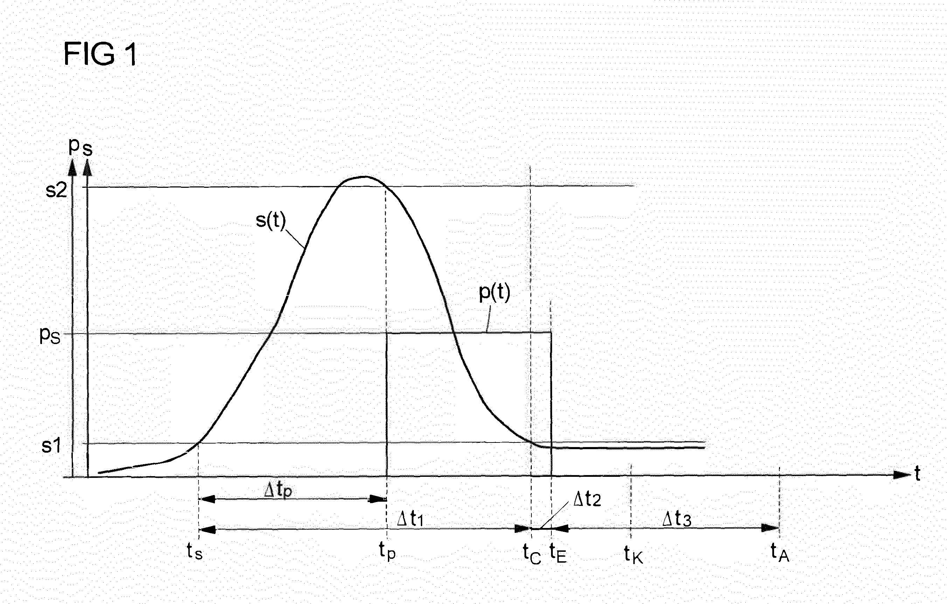

- Figur 1: ein Signal-Zeit-Diagramm für ein erstes Ausführungsbeispiel eines erfindungsgemäßen Verfahrens eines hiernach arbeitenden Ausführungsbeispiels für ein erfindungsgemäßes Steuerungssystem, bei dem das Senden eines Triggersignals zum Starten eines Authentifizierungsprozesses bereits begonnen wird, wenn anhand eines gemessenen Messsignalverlaufs noch nicht abschließend auswertbar ist, ob tatsächlich ein zulässiges Bedienereignis vorliegt, und das Triggersignal bei positiver Detektion eines Bedienereignisses erst vervollständigt wird, um den Authentifizierungsprozess tatsächlich auszulösen;

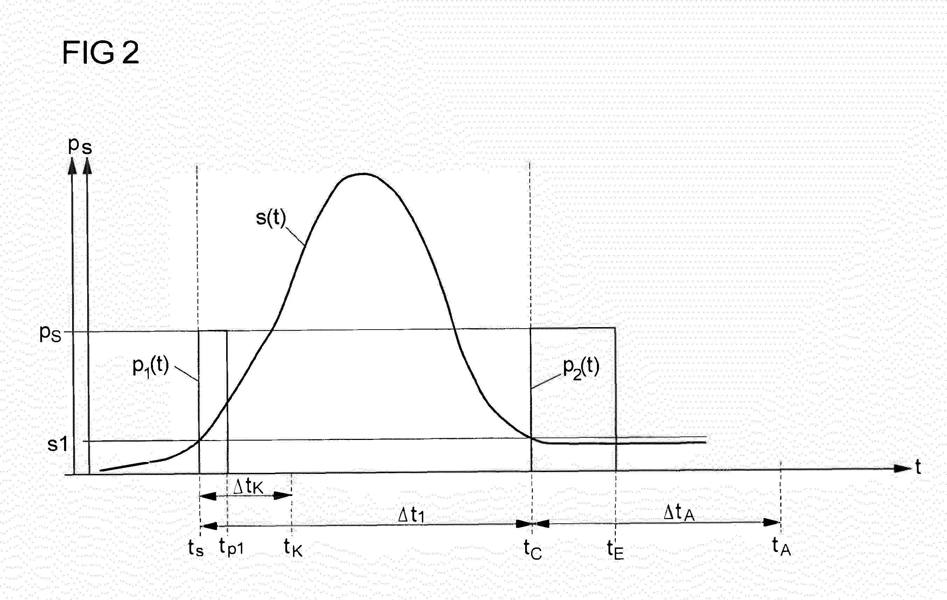

- Figur 2: ein Signal-Zeit-Diagramm für ein zweites, nicht erfindungsgemäßes Ausführungsbeispiel, bei dem ein Authentifizierungsprozess und eine Aktivierung eines Antriebs zum Verstellen eines Fahrzeugschließelements (ggf. mit vorgelagerter Betätigung eines Schlosses) über separate Triggersignale ausgelöst werden und ein Triggersignal zum Auslösen des Authentifizierungsprozesses bereits frühzeitig vor Abschluss der Detektion eines Bedienereignisses gesendet wird, jedoch ohne die nach dem ersten Aspekt vorgesehene Auslösung des Triggersignals zu einem Zeitpunkt innerhalb des Detektionszeitintervalls, an dem ein in einer elektronischen Steuereinrichtung hinterlegtes Kriterium betreffend die Anzahl erfasster Messwerte erfüllt ist;

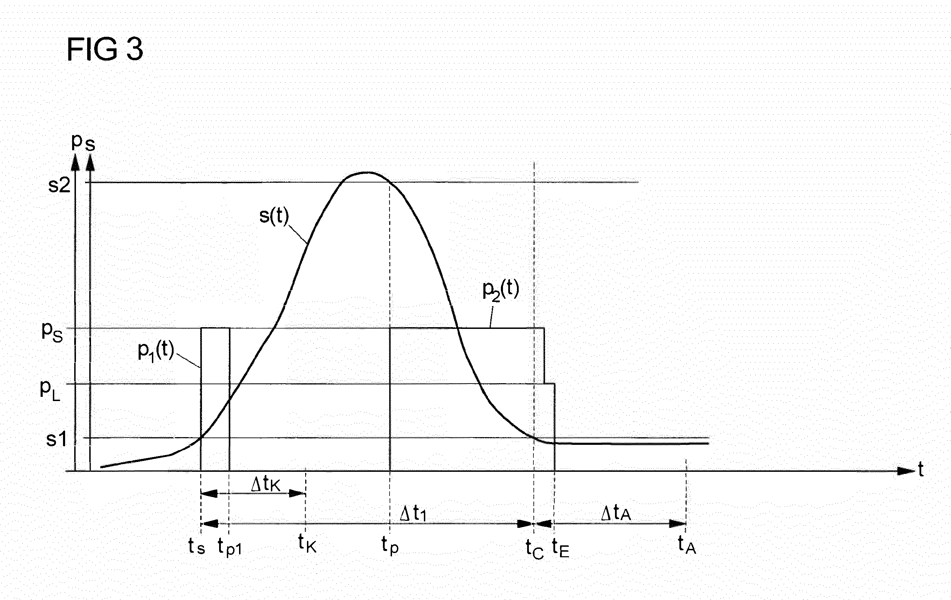

- Figur 3: ein Signal-Zeit-Diagramm für ein drittes Ausführungsbeispiel, bei dem analog zum zweiten Ausführungsbeispiel gemäß Figur 2 unterschiedliche Triggersignale für den Start eines Authentifizierungsprozesses und die Aktivierung eines Antriebs genutzt werden, in Abweichung von dem zweiten Ausführungsbeispiel jedoch das Senden des Triggersignals für die Aktivierung des Antriebs vor der Detektion eines Bedienereignisses begonnen und nur bei positiver Detektion des Bedienereignisses vervollständigt wird;

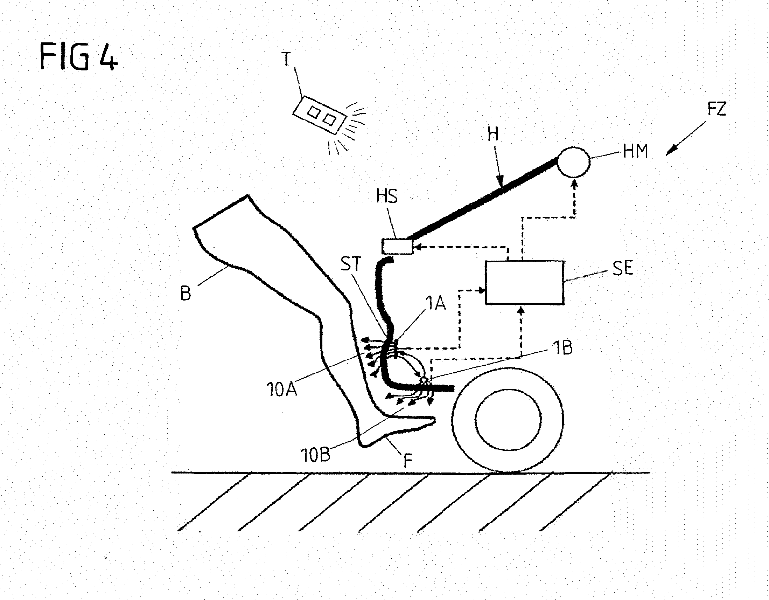

- Figur 4: schematisch das Heck eines Fahrzeugs mit einer Heckklappe als Fahrzeugschließelements unter Veranschaulichung eines erfindungsgemäßen Steuerungssystems;

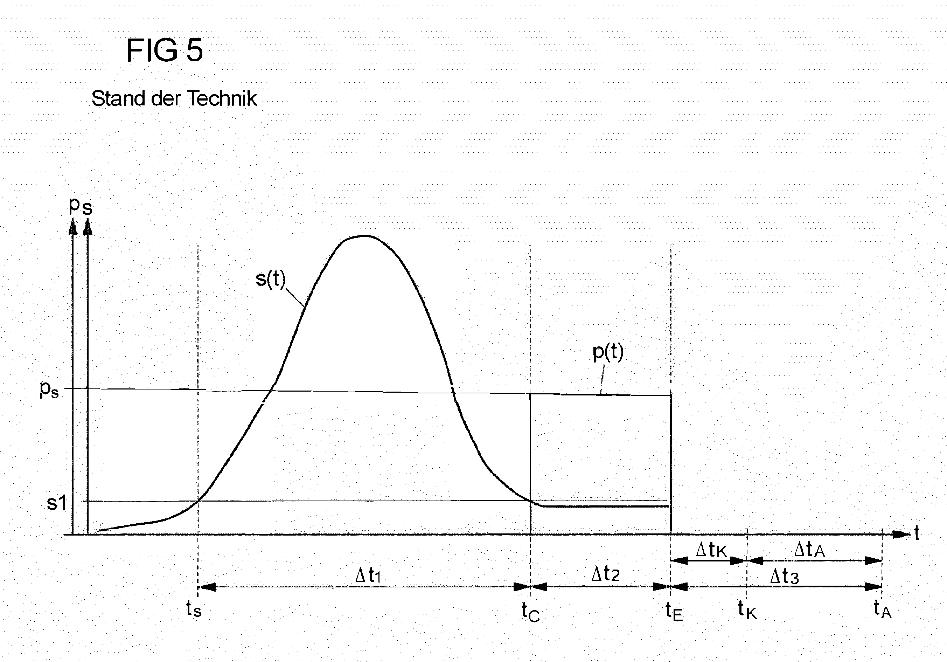

- Figur 5: ein Signal-Zeit-Diagramm für einen Ablauf eines aus dem Stand der Technik bekannten Steuerungsverfahrens.

Die Figur 4 zeigt eine Ausführungsvariante eines erfindungsgemäßen Steuerungssystems, das in einem Fahrzeug FZ Verwendung findet. Das Fahrzeug FZ weist ein Fahrzeugschließelement in Form einer Heccklappe H auf. Die Heckklappe H ist dabei mittels eines Heckklappenantriebs HM fremdkraftbetätigt verstellbar. Der Heckklappenantrieb HM weist hierfür beispielsweise wenigstens einen Elektromotor auf. In einem geschlossenen Zustand der Heckklappe H ist diese über ein Heccklappensschloss HS verriegelt und damit gegen ein unbefugtes Öffnen gesperrt.

Um die Heckklappe H zu öffnen, soll es ausreichen, dass ein berechtigter, respektive authentifizierter Benutzer eine Kick-Bewegung im Bereich eines heckseitigen Stoßfängers ST des Fahrzeugs FZ ausführt. Die mit einem Bein B und einem Fuß F des Benutzers ausgeführte Kick-Bewegung im Bereich des Stoßfängers ST soll dementsprechend als Bedienereignis berührungslos detektiert werden können. Hierfür ist eine Sensoreinrichtung mit mehreren, vorliegend wenigstens zwei kapazitiven Sensorelementen 1A und 1B des Steuerungssystems vorgesehen. Die Sensorelemente 1A und 1B sind räumlich zueinander separiert und überwachen unterschiedliche, sich gegebenenfalls überlappende Detektionsbereiche 10A und 10B vor und unter dem Stoßfänger ST, die gemeinsam einen Detektionsbereich des Steuerungssystems definieren, auf eine Annäherung des Benutzers und die Ausführung der Kick-Bewegung.

Mittels der Senderelemente 1A und 1B wird beispielsweise eine Kapazitätsänderung in den jeweiligen einem Sensorelement 1A oder 1B zugeordneten Detektionsbereichen 10A und 10B erfasst. Über die erfassten Messwerte für die sich ändernde Kapazität kann dann auf eine Kick-Bewegung geschlossen werden. Die mittels der Sensoreinrichtung 1A, 1B erfassten Messwerte werden hierbei von einer mit den Sensorelementen 1A und 1B verbundenen elektronischen Steuereinrichtung SE ausgewertet, die hierfür eine Auswertelogik integriert. Ergibt sich anhand eines Verlaufs von in einem Detektionszeitintervall erfassten Messwerten, dass ein Bedienereignis vorliegt, wird mittels der elektronischen Steuereinrichtung SE das Heckklappenschloss HS zur Entriegelung der Heckklappe H angesteuert sowie der Heccklappenantrieb HM zur Verstellung der Heckklappe H angesteuert.

Vor dem Verstellen der Heckklappe H, hier dem Öffnen der Heckklappe H, wird zuvor noch überprüft, ob sich in der Umgebung des Fahrzeugs F, d.h. in einem definierten Umkreis um das Fahrzeug FZ, ein gültiges Identifikationsmittel, zum Beispiel in Form eines Transponders T einer Fernbedienung für das Fahrzeug FZ, befindet. Es wird folglich beispielsweise geprüft, ob in der Umgebung des Fahrzeugs FZ ein gültiger Fahrzeugschlüssel vorhanden ist. Hieraus wird dann darauf geschlossen, dass die Kick-Bewegung von einem berechtigten / authentifizierten Benutzer ausgeführt wurde. Durch den entsprechenden Authentifizierungsprozess wird dementsprechend vermieden, dass jede im Bereich des Stoßfängers ST ausgeführte Kickbewegung (einer beliebigen Person) bereits zu einem Öffnen der Heccklappe H führt.

Das Signal-Zeit-Diagramm der Figur 5 veranschaulicht hierbei ein aus dem Stand der Technik bekanntes Verfahren zur Steuerung der Verstellbewegung der Heckklappe H beim Öffnen auf ein detektiertes, zulässiges Bedienereignis hin.

In dem Diagramm der Figur 5 ist einerseits ein Verlauf von durch die Sensoreinrichtung 1A, 1B erfassten Messwerten als Messsignal s über der Zeit t aufgetragen. Der in der Figur 5 dargestellte parabelförmige Verlauf des Messsignals s steht dabei repräsentativ für eine an dem Stoßfänger ST ausgeführte Kick-Bewegung und damit für eine positive Detektion eines Bedienereignisses. Darüber hinaus ist im Diagramm der Figur 5 eine zusätzliche Ordinate für die zeitliche Entwicklung eines Triggersignals p über der Zeit t vorgesehen. Eine Puls- oder Signalstärke p_{S} eines gesendeten Triggersignals p ist in dem dargestellten Diagramm (wie auch in den nachfolgend erläuterten Diagrammen) lediglich exemplarisch. Alternativ kann selbstverständlich auch ein codiertes Signal mit unterschiedlichen High- und Low-Pegel, eine Pulssequenz oder eine Pulsfolge mit wenigstens zwei unterschiedlichen Pulsstärken gesendet werden. Sendebeginn und Übertragungsdauer des Triggersignals p werden jeweils von der elektronischen Steuereinrichtung SE gesteuert.

Bei einer zu detektierenden Kick-Bewegung steigt zunächst das Messsignal s über einen hinterlegten Schwellwert s1 an. Zu einem Zeitpunkt ts, an dem der Schwellwert s1 überschritten wird, sind beispielsweise beide Sensorelement 1A und 1B aktiviert. Die elektronische Steuereinrichtung SE zieht daher ab diesem Zeitpunkt ts die Messwerte für die Auswertung in Betracht, ob tatsächlich ein zulässiges Bedienereignis vorliegt. Wird dann in einem nachfolgenden Detektionszeitintervall Δt₁ bis zu einem Zeitpunkt tc der dargestellte parabelförmige Verlauf des Messsignals s festgestellt, d.h. insbesondere der Anstieg bis zu einem Plateau oder Maximalwert des Messsignals s und ein anschließender Abfall unterhalb des Schwellwertes s1, bewertet dies eine Auswertelogik der elektronischen Steuereinrichtung 1A, 1B als gültiges Bedienereignis und sendet ein Triggersignal p in Form eines 400ms langen Pulses. Dieses Triggersignal p stellt vorliegend ein Auslösesignal für die Triggerung des Authentifizierungsprozesses dar, um zu prüfen, ob in der Umgebung des Fahrzeugs FZ ein gültiger Transponder T vorhanden ist. Die damit verbundene Schlüsselsuche wird somit nach einem Zeitintervall Δt₂ = 400ms nach dem Zeitpunkt tc des Erkennens eines zulässigen Bedienereignisses gestartet, und zwar nach dem vollständigem Empfang des 400ms langen Pulses zu einem Zeitpunkt t_{E}. Diese Schlüsselsuche und der damit verbundene Authentifizierungsprozess nimmt eine Zeit Δt_{K} in Anspruch. Wird dann zu einem Zeitpunkt t_{K} der Authentifizierungsprozess abgeschlossen und ein gültiger Transponder T detektiert, wird eine weitere, der eigentlichen Verstellung der Heckklappe H ebenfalls vorgelagerte Operation getriggert, nämlich die Ansteuerung des Heckklappeantriebs H sowie gegebenenfalls zuvor die Ansteuerung der Blinker und/oder Scheinwerfer des Fahrzeugs FZ, um einen Nutzer visuell über die erfolgreiche Erkennung eines Bedienereignisses zu informieren (bevor die Heckklappe H verstellt wird). Bis zur Verstellung der Heckklappe H über den Heckklappenantrieb HM vergeht dann nochmals ein weiteres Zeitintervall Δt_{A}, bis der Heckklappenantrieb H tatsächlich die Verstellung der Heckklappe H auslöst.

In dem mit der Figur 5 dargestellten Szenario mit aufeinanderfolgenden Signalisierung nach Abschluss der Detektion eines zulässigen Bedienereignisses vergeht somit vergleichsweise viel Zeit, bis tatsächlich eine Rückmeldung an den Nutzer erfolgt, dass das Bedienereignis erfolgreich erkannt wurde, und bis tatsächlich eine sichtbare Verstellung der Heckklappe H erfolgt. Dies führt dazu, dass ein Nutzer unter Umständen davon ausgeht, dass die von ihm ausgeführte Kick-Bewegung nicht erfolgreich mittels der Sensoreinrichtung 1A, 1B erkannt wurde. Der Nutzer führt somit die Kick-Bewegung nochmals aus oder versucht bereits, die Heckklappe H anderweitig zu öffnen. Es kann somit zu Fehlbedienungen und/oder Fehlfunktionen kommen.

Zur Erhöhung des Kundennutzens und der Kundenzufriedenheit wird es vor diesem Hintergrund als vorteilhaft erachtet, die Zeit zwischen dem erfolgreichen Detektieren eines zulässigen Bedienereignisses und der tatsächlichen Verstellung der Heckklappe H (oder eines anderen Fahrzeugschließelements) zu verkürzen. Im Rahmen der vorgeschlagenen Lösung ist dies dadurch erreicht, dass das Senden mindestens eines Triggersignals zur Triggerung einer der Verstellung des Fahrzeugschließelements, hier der Heckklappe H, zwingend vorgelagerten Operation zumindest teilweise bereits vor der Auswertung, ob ein zulässiges Bedienereignis vorliegt oder nicht, gesendet wird. Ferner kann in diesem Zusammenhang zur Vermeidung zusätzlicher Sensorelemente das Senden eines solchen Triggersignals für den Start eines Authentifizierungsprozesses von mindestens einem Messwert und damit dem Messsignal s abhängen, der/das ohnehin erfasst und ausgewertet wird, um ein Bedienereignis zu erkennen.

Bei einer Ausführungsvariante, die anhand des Diagramms der Figur 1 veranschaulicht ist, wird z.B. ein Triggersignal in Form eines Auslösesignals p mit einer vordefinierten Signallänge Δt₁ gesendet, um den Start eines Authentifizierungsprozesses zu einem Zeitpunkt t_{E} zu starten, der das Signalisierungsende und damit das Ende des 400ms-Pulses darstellt. Im Unterschied zu dem aus dem Stand der Technik bekannten Verfahren wird hierbei jedoch das Senden des Auslösesignals p für die Triggerung des Authentifizierungsprozesses bereits begonnen, bevor das Detektionszeitintervall Δt₁ abgeschlossen und damit für die elektronische Steuereinrichtung SE überhaupt abschließend auswertbar ist, ob tatsächlich ein zulässiges Bedienereignis vorliegt oder nicht. Der Beginn des Sendens des Auslösesignals p wird vielmehr bereits zu einem Zeitpunkt tp begonnen, an dem es grundsätzlich hinreichend wahrscheinlich erscheint, dass tatsächlich gerade eine Kick-Bewegung im Bereich des Stoßfängers ST ausgeführt wird und am Ende des Detektionszeitintervall Δt₁ ein zulässiges Bedienereignis detektiert werden wird.

Das/ein Kriterium für den Beginn des Sendens des Auslösesignals p zu dem Zeitpunkt t_{P} innerhalb des Detektionszeitintervall Δt₁ ist hierbei das Durchschreiten eines Maximums durch das erfasste Messsignal s. Das Durchschreiten dieses Maximum wird hierbei beispielsweise anhand eines zweiten Schwellwertes s2 (mit s2 > s1) festgestellt, wobei dieser zweite Schwellwert s2 ebenfalls in der Auswertelogik der elektronischen Steuereinrichtung SE hinterlegt ist. Die zu detektierende Kick-Bewegung wird somit in mindestens zwei Teilfunktionen zerlegt, einerseits in einen Pre-Kick und eine anschließende Bestätigung. Die Detektion eines Pre-Kick oder besser Pre-Kick-Ereignisses auf Basis des bisherigen Messsignals s in lediglich einem Teilbereich des Detektionszeitintervalls Δt₁ löst somit bereits das Senden des Auslösesignals p aus, gleichwohl das Vorliegen eines zulässigen Bedienereignisses erst zu dem späteren Zeitpunkt tc am Ende des Detektionszeitintervalls Δt₁ festgestellt werden kann.

Der mögliche Beginn des Sendens des Auslösesignals p und damit zum Beispiel die Höhe des zweiten Schwellwertes s2 und die Dauer des Auslösesignals p sind hierbei so aufeinander und auf das Detektionszeitintervall Δt₁ abgestimmt, dass bei einem einmal ausgelösten Senden des Auslösesignals p dieses Auslösesignal p zum Ende des Detektionszeitintervalls Δt₁ und damit zum Zeitpunkt der Auswertung und Erkennung eines zulässigen Bedienereignisses noch nicht vollständig gesendet wurde. Das Auslösesignal p wurde somit noch nicht über die vorgegebene, volle Signallänge, hier 400ms, gesendet, die zur Triggerung des Authentifizierungsprozesses notwendig ist.

Beispielsweise erfolgt der Beginn des Sendens des Auslösesignals p und damit der Start einer Pre-Kick-Signalisierung zu dem Zeitpunkt t_{P} frühestens zu einem Zeitpunkt innerhalb des Detektionszeitintervall Δt₁, an dem ein in der elektronischen Steuereinrichtung SE hinterlegtes Kriterium betreffend die Anzahl erfasster Messwerte erfüllt ist. Ein solches Kriterium kann beispielsweise das Überschreiten einer Mindestanzahl an Messwerten umfassen, die zur Verfügung stehen muss, um ein Bedienereignis mit einer hinreichenden Wahrscheinlichkeit annehmen zu können. Beispielsweise erfolgt der Beginn des Sendens des Auslösesignals p, nachdem mehr als die Hälfte des Detektionszeitintervalls Δt₁ verstrichen ist. Der Beginn des Sendens des Auslösesignals p nach Verstreichen eines Zeitintervalls At_{P} (mit Δt_{P} > ½Δt₁) nach dem Beginn des Detektionszeitintervalls (zu einem Zeitpunkt ts) ist somit stets so groß, dass zum Ende des Direktionszeitintervalls Δt₁ nie ein vollständiges und damit zum Auslösen des Authentifizierungsprozesses geeignetes Auslösesignal vorliegt. Damit kann das Senden des Auslösesignals p am Ende des Detektionszeitintervalls Δt₁ noch abgebrochen werden, sofern kein zulässiges Bedienereignis detektiert wird. Das unvollständig gesendete Auslösesignal p bleibt ohne Wirkung und löst den Start des Authentifizierungsprozesses nicht aus. Wird demgegenüber ein gültiges Bedienereignis detektiert, wird das Senden des Auslösesignals p verlängert, sodass das Auslösesignal p weiter bis zum Erreichen der definierten Signallänge (hier t_{E} - t_{P}) gesendet wird und damit der Authentifizierungsprozess gestartet wird.

Durch die bereits vorgelagerte und zu der Erfassung eines Bedienereignisses parallel verlaufende teilweise Übertragung des Auslösesignals p für die Auslösung des Authentifizierungsprozesses wird eine deutliche Verkürzung des Zeitintervalls erreicht, dass zwischen dem Beginn der Ausführung der Kick-Bewegung durch einen Nutzer und der tatsächlichen Verstellung der Heckklappe H verstreicht. Geht man beispielsweise beim mit dem Diagramm der Figur 5 dargestellten Stand der Technik von einer Größe dieses Zeitintervalls von 1550ms aus, lässt sich bei der Ausführungsvariante entsprechend dem Diagramm der Figur 1 dieses Zeitintervall auf 1250ms verkürzen. Die Ansteuerung einer elektronischen Authentifizierungslogik sowie einer Steuerelektronik des Heckklappenantriebs HM erfolgt hierbei beispielsweise über einen CAN- oder LIN-Bus.

Bei der mit dem Diagramm der Figur 2 dargestellten Ausführungsvariante sind zwei unterschiedliche Triggersignale p₁ und p2 in Form eines Auslösesignal p₁ und eines Steuersignals p₂ vorgesehen, die zu unterschiedlichen Zeitpunkten gesendet werden, um einerseits den Authentifizierungsprozess und mithin die Schlüsselsuche und andererseits die Aktivierung des Heckklappenantriebs HM (einschließlich der Betätigung des Heckklappenschlosses HS zur Freigabe der Heccklappe H) auszulösen.

So wird in der dargestellten Ausführungsvariante bereits zu Beginn des Detektionszeitintervalls Δt₁ und dabei durch Überschreiten des Schwellwertes s1 durch das Messesignal s das Senden des Auslösesignals p₁ ausgelöst. Die Übertragung dieses Auslösesignal p₁ erfolgt beispielsweise über einen LIN-Bus. Ist das Auslösesignal p₁ zu einem Zeitpunkt t_{P1} vollständig gesendet, wird hiermit der Authentifizierungsprozess und insbesondere die Schlüsselsuche ausgelöst, noch während das Messsignal s weiter erfasst wird, um zu dem späteren Zeitpunkt t_{C} bewerten zu können, ob tatsächlich ein zulässiges Bedienereignis vorliegt oder nicht. Die üblicherweise weniger als 200ms, z.B. 150ms, in Anspruch nehmende Schlüsselsuche ist dann zu einem Zeitpunkt t_{K} innerhalb des Detektionszeitintervalls Δt₁ abgeschlossen. In dieser Variante sind somit die Länge des zur Auslösung des Authentifizierungsprozesses zu übertragenden Auslösesignals p₁ und die Dauer der Schlüsselsuche somit aufeinander und auf das Detektionszeitintervall Δt₁ abgestimmt, dass ein Zeitintervall At_{K}, das zwischen dem Beginn des Sendens des Auslösesignal p₁ und dem Ende der Schlüsselsuche verstrichen ist, vollständig innerhalb des Detektionszeitintervalls Δt₁ liegt.

Die Schlüsselsuche ist somit nach Erkennung eines Pre-Kick-Ereignisses somit in jedem Fall bereits abgeschlossen, bevor ausgewertet wird, ob tatsächlich ein zulässiges Bedienereignis vorliegt oder nicht. Am Ende des Detektionszeitintervalls Δt₁ und bei positiver Detektion eines Bedienereignisses muss somit nur noch über das Senden des Steuersignals p₂ die Aktivierung des Heckklappenantriebs HM sowie gegebenenfalls eine Blinkeransteuerung getriggert werden. Werden beide Triggersignale p₁ und p₂ für die Triggerung des Authentifizierungsprozesses und für die Aktivierung des Heccklappenantriebs HM (sowie des Heckklappenschlosses HS) über einen LIN-Bus übertragen, lässt sich auch hier die Zeit problemlos auf 1100ms verkürzen, die zwischen dem Beginn einer Kick-Bewegung bis zur eigentlichen Verstellung der Heckklappe H verstreicht.

Bei der mit dem Diagramm der Figur 3 dargestellten Ausführungsvariante sind die beiden Aspekte der Ausführungsvarianten der Figuren 1 und 2 miteinander kombiniert. So wird auch hier der Authentifizierungsprozess frühzeitig bereits bei einer Erkennung eines Pre-Kick-Ereignisses durch Erzeugen und Senden eines ersten Triggersignals in Form eines Auslösesignals p₁ ausgelöst, sodass der Authentifizierungsprozess noch innerhalb des Detektionszeitintervalls Δt₁ abgeschlossen ist. Ferner wird ein zweites Triggersignal in Form eines Steuersignals p₂ zur Aktivierung des Heckklappenantriebs HM (sowie bei verriegelter Heckklappe H zum vorherigen oder gleichzeitigen Ansteuern des Heckklappenschlosses HS) noch zu einem Zeitpunkt tp innerhalb des Detektionszeitintervall Δt₁ begonnen. Getriggert wird das Senden des Steuersignals p₂ hierbei erneut beispielsweise durch das Unterschreiten des zweiten Schwellwertes s2 durch das Messsignal s, nachdem das Messsignal s ein Maximum erreicht hatte, wie es mit einem Zurückschwenken eines Fußes F des Nutzers einhergeht.

Wird zum Ende des Selektionszeitintervall Δt₁ kein Bedienereignis mittels der elektronischen Steuereinrichtung SE festgestellt, wird das Senden des Steuersignals p₂ abgebrochen, sodass dieses unvollständig bleibt und - unabhängig vom Ausgang des Authentifizierungsprozesses - keine Ansteuerung des Heckklappenantriebs HM (und gegebenenfalls des Heckklappenschlosses HS und der Fahrzeugblinker) erfolgt.

Wird demgegenüber zum Ende des Selektionszeitintervall Δt₁ ein gültiges Bedienereignis anhand des Verlaufs des Messesignals s und der diesen Verlauf bildenden Messwerte detektiert, wird das Steuersignal p₂ weiter bis zur die Aktivierung des Heckklappenantriebs HM auslösenden Signallänge t_{E} - t_{P} gesendet und damit vervollständigt. Das weitere Senden des Steuersignals p₂ hängt jeweils letztendlich auch von der positiven Authentifizierung eines gültigen Transponders T am Ende des Authentifizierungsprozesses (zum Zeitpunkt t_{K}) ab. Mit anderen Worten wird das Senden des Steuersignals p₂ nur bei Detektion eines gültigen Bedienereignisses zum Ende des Detektionszeitintervalls Δt₁ fortgesetzt, jedoch abgebrochen, wenn zuvor kein gültiger Transponder T in der Umgebung des Fahrzeugs FZ detektiert worden ist.

Im Diagramm der Figur 3 ist das Steuersignal p₂ zur Ansteuerung des Heckklappenantriebs HM exemplarisch als High-Low-Sequenz dargestellt. Ein vollständiges Steuersignal p₂, das die Aktivierung des Heckklappenantriebs HM auslöst, enthält somit eine definierte Signal- oder Pulsfolge, vorliegend zum Beispiel mit einem Puls einer ersten Signal- oder Pulsstärke p_{S} gefolgt von einem Signal oder einem Puls mit einer zweiten (hier: niedrigeren) Signal- oder Pulsstärke p_{L}. Wird diese Sequenz nur unvollständig übertragen, erfolgt keine Aktivierung des Heckklappenantriebs HM. Dementsprechend kann beispielsweise der frühestmögliche Zeitpunkt t_{P} für den Beginn des Sendens des Steuersignals p₂ innerhalb des Detektionszeitintervalls Δt₁ derart vorgegeben sein, dass zum Ende des Detektionszeitintervalls Δt₁ stets nur ein Teil der Sequenz übertragen wurde und erst bei Detektion eines zulässigen Bedienereignisses die Sequenz des Steuersignals p₂ vervollständigt wird, beispielsweise mit dem Signal- oder Pulsanteil niedrigerer Signal- oder Pulsstärke p_{L}.

Empfänger der jeweiligen Triggersignale p, p₁ und p₂ können beispielsweise elektronische Steuereinrichtungen besondere Steuergeräte innerhalb des Fahrzeugs FZ sein, die beispielsweise die Schlüsselsuche steuern oder dem Heckklappensschloss HS und dem Heckklappenantrieb HM zugeordnet sind und die über einen LIN- oder CAN-Bus mit der elektronischen Steuereinrichtung SE in Verbindung stehen.

Die Erzeugung und der Beginn des Sendens eines Triggersignals p, p₁ oder p₂ kann grundsätzlich von mindestens einem zusätzlichen Kriterium abhängig sein, insbesondere von einem Messwert der Sensorelemente 1A oder 1B und/oder von einem Messwert eines weiteren (hier nicht dargestellten) Sensorelements. So kann beispielsweise das Senden des Triggersignals / Auslösesignals p₁ für den Start eines Authentifizierungsprozesses vermieden werden, wenn sich anhand einer zusätzlichen Auswertung ergibt, dass das Vorliegen eines Pre-Kick-Ereignisses und damit auch zu einem späteren Zeitpunkt das Vorliegen eines zulässigen Bedienereignisses unwahrscheinlich ist. Hierfür kann beispielsweise eine zeitliche Entwicklung aufeinanderfolgender Messwerte für das Messsignal s und/oder der Wert eines Maximums erfasster Messwerte in dem Detektionszeitintervall Δt1 oder einem Teilintervall dieses Detektionszeitintervalls Δt1 herangezogen werden.

Es ist hierbei selbstverständlich nicht zwingend, dass das mindestens eine zusätzliche Kriterium für den Beginn des Sendens eines Triggersignals p, p₁ oder p₂ auch für die abschließende Auswertung herangezogen wird, ob ein gültiges Bedienereignis vorliegt oder nicht. So kann das mindestens eine zusätzliche Kriterium mit Blick auf die Auswertung, ob ein zulässiges Bedienereignis vorliegt, einen zumindest teilweise redundanten Informationsgehalt aufweisen. Während der Ausführung einer Kick-Bewegung kann dieses zusätzliche Kriterium aber bereits genutzt werden, um einen realen Kick (an den oder in Richtung des Stoßfängers ST) auszuschließen.

### Bezugszeichenliste

- 1A, 1B: Sensorelement
- 10A, 10B: Detektionsbereich
- B: Bein
- F: Fuß
- FZ: Fahrzeug
- H: Heckklappe (Fahrzeugschließelement)
- HM: Heckklappenantrieb
- HS: Heckklappenschloss
- p, p₁, p₂: Auslöse-/ Steuersignal (Triggersignal)
- p_{S}: Puls- Signalstärke
- s: Messsignal
- s1, s2: Schwellwert
- SE: Elektronische Steuereinrichtung
- ST: Stoßfänger
- t: Zeit
- T: Transponder (Identifikationsmittel)
- t_{A}: Aktivierungsende
- t_{C}: Zeitpunkt der Erkennung eines zulässigen Bedienereignisses
- t_{E}: Signalisierungsende
- t_{K}: Zeitpunkt des Abschlusses der Schlüsselsuche / des Authentifizieru ngsprozess
- t_{P}: Start der Pre-Kick-Signalisierung
- t_{P1}: Start der Vorab-Signalisierung
- t_{S}: Beginn der Auswertung für mögliches Bedienereignis

## Patentansprüche

1. Verfahren zur Steuerung einer Verstellbewegung eines fremdkraftbetätigt verstellbaren Fahrzeugschließelements (H), über das eine Karosserieöffnung eines Fahrzeugs (FZ) verschließbar ist und das zum Freigeben der Karosserieöffnung bei Vorliegen eines Bedienereignisses automatisch verstellt werden kann, wobei
- mittels einer Sensoreinrichtung (1A, 1B) als Bedienereignis berührungslos detektiert wird, dass eine Person mit einem Körperteil (F) eine bestimmte Bewegung in einem Detektionsbereich (10A, 10B) ausführt, und zur Detektion des Bedienereignisses ein Verlauf von durch die Sensoreinrichtung (1A, 1B) in einem Detektionszeitintervall (Δt₁) erfassten Messwerten ausgewertet wird, und
- wenigstens ein Triggersignal (p, p₂) erzeugt und gesendet wird, das eine der Verstellung des Fahrzeugschließelements (H) vorgelagerte Durchführung eines Authentifizierungsprozesses triggert, bei dem das Vorliegen eines gültigen Identifikationsmittels (T) in einer Umgebung des Fahrzeugs (FZ) überprüft wird,
wobei mindestens ein für das Vorliegen eines Bedienereignisses erfasster Messwert genutzt wird, das Senden des Triggersignals (p, p₁, p₂) für den Authentifizierungsprozess auszulösen, bevor das Detektionszeitintervall (Δt₁) verstrichen ist und bevor der Verlauf der Messwerte dahingehend auswertet werden kann, ob ein Bedienereignis vorliegt,
**dadurch gekennzeichnet, dass**
das Senden des Triggersignals (p, p₁) zu einem Zeitpunkt (t_{S}) innerhalb des Detektionszeitintervall (Δt₁), an dem ein in einer elektronischen Steuereinrichtung (SE) hinterlegtes Kriterium betreffend die Anzahl erfasster Messwerte erfüllt ist, ausgelöst wird.

2. Verfahren nach Anspruch 1, **dadurch gekennzeichnet, dass** das Senden des Triggersignals (p₁) für den Start des Authentifizierungsprozesses zu einem Zeitpunkt (t_{P1}) abgeschlossen ist, bevor das Detektionszeitintervall (Δt₁) verstrichen ist.

3. Verfahren nach Anspruch 2, **dadurch gekennzeichnet, dass** der mit dem Triggersignal ausgelöste Authentifizierungsprozess zu einem Zeitpunkt (t_{K}) abgeschlossen ist, bevor das Detektionszeitintervall (Δt₁) verstrichen ist und bevor eine ausreichende Anzahl Messwerte erfasst wurde, um auszuwerten, ob ein Bedienereignis vorliegt oder nicht.

4. Verfahren nach Anspruch 1, **dadurch gekennzeichnet, dass**, wenn ein Bedienereignis detektiert wurde, das Senden des Triggersignals (p) zu einem Zeitpunkt (t_{E}) abgeschlossen wird, nachdem das Detektionszeitintervall (Δt₁) verstrichen ist.

5. Verfahren zur Steuerung einer Verstellbewegung eines fremdkraftbetätigt verstellbaren Fahrzeugschließelements (H), über das eine Karosserieöffnung eines Fahrzeugs (FZ) verschließbar ist und das zum Freigeben der Karosserieöffnung bei Vorliegen eines Bedienereignisses automatisch verstellt werden kann, wobei
- mittels einer Sensoreinrichtung (1A, 1B) als Bedienereignis berührungslos detektiert wird, dass eine Person mit einem Körperteil (F) eine bestimmte Bewegung in einem Detektionsbereich (10A, 10B) ausführt, und zur Detektion des Bedienereignisses ein Verlauf von durch die Sensoreinrichtung (1A, 1B) in einem Detektionszeitintervall (Δt₁) erfassten Messwerten ausgewertet wird, und
- wenigstens Triggersignal (p, p₂) mit einer definierten Signallänge (t_{E} - t_{P}) erzeugt und gesendet wird, das mindestens eine der Verstellung des Fahrzeugschließelements (H) vorgelagerte Operation triggert,
**dadurch gekennzeichnet, dass**
zu einem Zeitpunkt (tp) in dem Detektionszeitintervall (Δt₁) das Senden des Triggersignals (p, p₂) begonnen wird, sodass am Ende des Detektionszeitintervalls (Δt₁) das Triggersignal (p, p₂) die definierte Signallänge (t_{E} - t_{P}) noch nicht erreicht hat, und das Triggersignal (p, p₂) nur bei Detektion eines Bedienereignisses weiter bis zum Erreichen der definierten Signallänge (t_{E} - t_{P}) gesendet, ansonsten aber dessen Senden abgebrochen wird.

6. Verfahren nach Anspruch 5, **dadurch gekennzeichnet, dass** das Senden des Triggersignals (p, p₂) abgebrochen wird, wenn kein Bedienereignis detektiert wurde, sodass das Triggersignal (p, p₂) unvollständig bleibt und die der Verstellung des Fahrzeugschließelements (H) vorgelagerte Operation nicht getriggert wird.

7. Verfahren nach einem der vorhergehenden Ansprüche, **dadurch gekennzeichnet, dass** das Über- oder Unterschreiten eines vorgegebenen Schwellwertes (s1, s2) den Beginn des Sendens des Triggersignals (p, p₁, p₂) auslöst, bevor das Detektionsintervall (Δt₁) verstrichen und ausgewertet ist, ob ein Bedienereignis vorliegt oder nicht.

8. Verfahren nach einem der vorhergehenden Ansprüche, **dadurch gekennzeichnet, dass** für das Verstellen des Fahrzeugschließelements (H) ein Antrieb (HM) mittels eines Steuersignals (p₂) aktiviert wird, wobei das Senden des Steuersignals (p₂) begonnen wird, nachdem das Detektionszeitintervall (Δt₁) verstrichen und ausgewertet ist, ob ein Bedienereignis vorliegt.

9. Verfahren nach einem der vorhergehenden Ansprüche, **dadurch gekennzeichnet, dass** mittels der Sensoreinrichtung (1A, 1B) berührungslos eine durch eine Person ausgeführte Kick-Bewegung als Bedienereignis detektierbar ist.

10. Verfahren nach einem der vorhergehenden Ansprüche, **dadurch gekennzeichnet, dass** die Erzeugung und der Beginn des Sendens des Triggersignals (p, p₁, p₂) von mindestens einem zusätzlichen Kriterium abhängig ist.

11. Verfahren nach einem der vorhergehenden Ansprüche, **dadurch gekennzeichnet, dass** das mindestens eine zusätzliche Kriterium eine zeitliche Entwicklung aufeinanderfolgend erfasster Messwerte ist und/oder der Wert eines Maximums erfasster Messwerte ist.

12. Steuerungssystem für eine Verstelleinrichtung zum fremdkraftbetätigten Verstellen eines Fahrzeugschließelements, über das eine Karosserieöffnung eines Fahrzeugs verschließbar ist und das zum Freigeben der Karosserieöffnung bei Vorliegen eines Bedienereignisses automatisch verstellt werden kann, mit:
- einer Sensoreinrichtung (1A, 1B), mittels der als Bedienereignis berührungslos detektierbar ist, dass eine Person mit einem Körperteil (F) eine bestimmte Bewegung in einem Detektionsbereich (10A, 10B) ausführt, und
- einer elektronischen Steuereinrichtung (SE), mittels der
o ein Verlauf von durch die Sensoreinrichtung (1A, 1B) in einem Detektionszeitintervall (Δt₁) erfassten Messwerten dahingehend auswertbar ist, ob ein Bedienereignis vorliegt, und
o wenigstens ein Triggersignal (p, p₁, p₂) definierter Signallänge (t_{E} - t_{P}) erzeugt und gesendet werden kann, das mindestens eine der Verstellung des Fahrzeugschließelements (H) vorgelagerte Operation triggert,
**dadurch gekennzeichnet, dass**
die elektronische Steuereinrichtung (SE) konfiguriert ist,
a) mindestens einen für das Vorliegen eines Bedienereignisses erfassten Messwert zu nutzen, das Senden eines Triggersignals (p, p₁) für einen Authentifizierungsprozess, bei dem das Vorliegen eines gültigen Identifikationsmittels (T) in einer Umgebung des Fahrzeugs (FZ) überprüft wird, auszulösen, bevor das Detektionszeitintervall (Δt₁) verstrichen ist und der Verlauf der Messwerte dahingehend auswertet werden kann, ob ein Bedienereignis vorliegt, wobei das Senden des Triggersignals (p, p₁) zu einem Zeitpunkt (t_{S}) innerhalb des Detektionszeitintervall (Δt₁), an dem ein in einer elektronischen Steuereinrichtung (SE) hinterlegtes Kriterium betreffend die Anzahl erfasster Messwerte erfüllt ist, ausgelöst wird, und/oder
b) zu einem Zeitpunkt (tp) in dem Detektionszeitintervall (Δt₁) das Senden des Triggersignals (p, p₂) zu beginnen, sodass am Ende des Detektionszeitintervalls (Δt₁) das Triggersignal (p, p₂) die definierte Signallänge (t_{E} - t_{P}) noch nicht erreicht hat und das Triggersignal (p, p₂) nur bei Detektion eines Bedienereignisses weiter bis zum Erreichen der definierten Signallänge (t_{E} - t_{P}) gesendet, ansonsten aber dessen Senden abgebrochen wird.

## Claims

1. Method for controlling an adjustment movement of a vehicle closure element (H) that is adjustable in a manner actuated by external force, via which a bodywork opening of a vehicle (FZ) can be closed and which can be automatically adjusted for releasing the bodywork opening in the case of an operating event being present, wherein
- a sensor device (1A, 1B) detects, in a contactless manner, as the operating event, that a person performs a certain movement with a body part (F) in a detection region (10A, 10B), and for detection of the operating event a curve of measured values acquired by the sensor device (1A, 1B) in a detection time interval (Δt₁) is evaluated, and
- at least one trigger signal (p, p₂) is triggered and sent, which signal triggers a performance of an authentication process which precedes the adjustment of the vehicle closure element (H) and in which the presence of a valid identification means (T) in a surrounding of the vehicle (FZ) is checked,
wherein at least one measured value acquired for the presence of an operating event is used to cause the sending of the trigger signal (p, p₁, p₂) for the authentication process, before the detection time interval (Δt₁) has elapsed and before the curve of the measured values can be evaluated with regard to whether an operating event is present,
**characterised in that**
the sending of the trigger signal (p, p₁) is triggered at a timepoint (tₛ) within the detection time interval (Δt₁) at which a criterion, stored in an electronic control means (SE), relating to the number of acquired measured values is fulfilled.

2. Method according to claim 1, **characterised in that** the sending of the trigger signal (p₁) for the start of the authentication process is concluded at a timepoint (tₚ₁), before the detection time interval (Δt₁) has elapsed.

3. Method according to claim 2, **characterised in that** the authentication process triggered by the trigger signal is completed at a timepoint (tₖ), before the detection time interval (Δt₁) has elapsed and before a sufficient number of measured values has been acquired in order to evaluate whether or not an operating event is present.

4. Method according to claim 1, **characterised in that**, when an operating event has been detected, the sending of the trigger signal (p) is completed at a timepoint (t_{E}) after the detection time interval (Δt₁) has elapsed.

5. Method for controlling an adjustment movement of a vehicle closure element (H) that is adjustable in a manner actuated by external force, via which a bodywork opening of a vehicle (FZ) can be closed and which can be automatically adjusted for releasing the bodywork opening in the case of an operating event being present, wherein
- a sensor device (1A, 1B) detects, in a contactless manner, as the operating event, that a person performs a certain movement with a body part (F) in a detection region (10A, 10B), and for detection of the operating event a curve of measured values acquired by the sensor device (1A, 1B) in a detection time interval (Δt₁) is evaluated, and
- at least one trigger signal (p, p₂) of a defined signal length (t_{E} - tₚ) is generated and sent, which signal triggers at least one operation that precedes the adjustment of the vehicle closure element (H),
**characterised in that**
at a timepoint (tₚ) in the detection time interval (Δt₁) the sending of the trigger signal (p, p₂) is started, such that at the end of the detection time interval (Δt₁) the trigger signal (p, p₂) has not yet reached the defined signal length (t_{E} - tₚ), and the trigger signal (p, p₂) is sent further until the defined signal length (t_{E} - tₚ) is reached only upon detection of an operating event, but otherwise the sending thereof is terminated.

6. Method according to claim 5, **characterised in that** the sending of the trigger signal (p, p₂) is terminated if no operating event was detected, such that the trigger signal (p, p₂) remains incomplete and the operation preceding the adjustment of the vehicle closure element (H) is not triggered.

7. Method according to any of the preceding claims, **characterised in that** exceeding or falling below a predetermined threshold value (s1, s2) triggers the start of the sending of the trigger signal (p, p₁, p₂) before the detection interval (Δt₁) has elapsed and an evaluation has been made as to whether or not an operating event is present.

8. Method according to any of the preceding claims, **characterised in that** for the adjustment of the vehicle closure element (H) a drive (HM) is activated by means of a control signal (p₂), wherein the sending of the control signal (p₂) is begun after the detection time interval (Δt₁) has elapsed and an evaluation has been made as to whether an operating event is present.

9. Method according to any of the preceding claims, **characterised in that** a kick movement performed by a person can be detected as the operating event in a contactless manner by the sensor means (1A, 1B).

10. Method according to any of the preceding claims, **characterised in that** the generation and the start of the sending of the trigger signal (p, p₁, p₂) is dependent on at least one additional criterion.

11. Method according to any of the preceding claims, **characterised in that** the at least one additional criterion is a temporal development of successively acquired measured values and/or the value of a maximum of acquired measured values.

12. Control system for an adjustment device for adjustment, in a manner actuated by external force, of a vehicle closure element via which a bodywork opening of a vehicle can be closed and which can be automatically adjusted for releasing the bodywork opening in the case of an operating event being present, comprising:
- a sensor device (1A, 1B), by means of which it is possible to detect, in a contactless manner, as the operating event, that a person performs a certain movement with a body part (F) in a detection region (10A, 10B), and
- an electronic control means (SE), by which
∘ a curve of measured values acquired by the sensor means (1A, 1B) in a detection time interval (Δt₁) can be evaluated with respect to whether an operating event is present, and
∘ at least one trigger signal (p, p₁, p₂) of defined signal length (t_{E} - tₚ) can be generated and sent, which signal triggers at least one operation that precedes the adjustment of the vehicle closure element (H),
**characterised in that**
the electronic control means (SE) is configured
a) to use at least one measured value, acquired for the presence of an operating event, to trigger the sending of a trigger signal (p, p₁) for an authentication process, in which the presence of a valid identification means (T) in a surrounding of the vehicle (FZ) is checked, before the detection time interval (Δt₁) has elapsed, and the curve of the measured values can be evaluated with regard to whether an operating event is present, wherein the sending of the trigger signal (p, p₁) is triggered at a timepoint (tₛ) within the detection time interval (Δt₁) at which a criterion stored in an electronic control means (SE) and relating to the number of acquired measured values is fulfilled, and/or
b) to start the sending of the trigger signal (p, p₂) at a timepoint (tₚ) in the detection time interval (Δt₁), such that at the end of the detection time interval (Δt₁) the trigger signal (p, p₂) has not yet reached the defined signal length (t_{E} - tₚ), and the trigger signal (p, p₂) is sent further, until it reaches the defined signal length (t_{E} - tₚ), only upon detection of an operating event, but otherwise the sending is terminated.

## Revendications

1. Procédé pour commander un mouvement d'ajustement d'un élément de fermeture de véhicule (H) ajustable par l'actionnement d'une force extérieure, par l'intermédiaire duquel une ouverture de carrosserie d'un véhicule (FZ) peut être fermée et qui peut être ajusté automatiquement pour dégager l'ouverture de carrosserie en présence d'un événement d'utilisation, dans lequel
- il est détecté sans contact en tant qu'événement d'utilisation au moyen d'un dispositif de capteur (1A, 1B) qu'une personne exécute avec une partie corporelle (F) un mouvement défini dans une zone de détection (10A, 10B) et, pour détecter l'événement d'utilisation, une évolution de valeurs de mesure détectées par le dispositif de capteur (1A, 1B) dans un laps de temps de détection (Δt₁) est évaluée, et
- au moins un signal de déclenchement (p, p₂) est généré et envoyé, qui déclenche une mise en oeuvre, ayant lieu avant l'ajustement de l'élément de fermeture de véhicule (H), d'un processus d'authentification, dans lequel la présence d'un moyen d'identification (T) valable est vérifiée dans un environnement du véhicule (FZ),
dans lequel au moins une valeur de mesure détectée pour la présence d'un événement d'utilisation est utilisée pour déclencher l'envoi du signal de déclenchement (p, p₁, p₂) pour le processus d'authentification avant que le laps de temps de détection (Δt₁) ne soit écoulé et avant que l'évolution des valeurs de mesure ne puisse être évaluée pour savoir si un événement d'utilisation est présent,
**caractérisé en ce que**
l'envoi du signal de déclenchement (p, p₁) est déclenché à un moment (tₛ) dans le laps de temps de détection (Δt₁), auquel un critère enregistré dans un dispositif de commande électronique (SE) concernant le nombre de valeurs de mesure détectées est rempli.

2. Procédé selon la revendication 1, **caractérisé en ce que** l'envoi du signal de déclenchement (p₁) pour le lancement du processus d'authentification est terminé à un moment (t_{P1}) avant que le laps de temps de détection (Δt₁) ne soit écoulé.

3. Procédé selon la revendication 2, **caractérisé en ce que** le processus d'authentification déclenché avec le signal de déclenchement est terminé à un moment (tₖ) avant que le laps de temps de détection (Δt₁) ne soit écoulé et avant qu'un nombre suffisant de valeurs de mesure ne soit détecté pour évaluer si un événement d'utilisation est présent ou non.

4. Procédé selon la revendication 1, **caractérisé en ce que**, lorsqu'un événement d'utilisation a été détecté, l'envoi du signal de déclenchement (p) est terminé à un moment (t_{E}) après que le laps de temps de détection (Δt₁) est écoulé.

5. Procédé pour commander un mouvement d'ajustement d'un élément de fermeture de véhicule (H) ajustable par l'actionnement d'une force extérieure, par l'intermédiaire duquel une ouverture de carrosserie d'un véhicule (FZ) peut être fermée et qui peut être ajusté automatiquement en présence d'un événement d'utilisation pour dégager l'ouverture de carrosserie, dans lequel
- il est détecté sans contact en tant qu'événement d'utilisation au moyen d'un dispositif de capteur (1A, 1B) qu'une personne exécute avec une partie corporelle (F) un mouvement défini dans une zone de détection (10A, 10B) et, pour détecter l'événement d'utilisation, une évolution de valeurs de mesure détectées par le dispositif de capteur (1A, 1B) dans un laps de temps de détection (Δt₁) est évaluée, et
- au moins un signal de déclenchement (p, p₂) est généré et envoyé avec une longueur de signal définie (t_{E} - t_{P}), qui déclenche au moins une opération ayant lieu avant l'ajustement de l'élément de fermeture de véhicule (H),
**caractérisé en ce que**
l'envoi du signal de déclenchement (p, p₂) commence à un moment (t_{P}) dans le laps de temps de détection (Δt₁) de sorte qu'à la fin du laps de temps de détection (Δt₁), le signal de déclenchement (p, p₂) n'a pas encore atteint la longueur de signal définie (t_{E} - t_{P}), et le signal de déclenchement (p, p₂) est envoyé seulement en cas de détection d'un événement d'utilisation jusqu'à ce que la longueur de signal définie (t_{E} - t_{P}) soit atteinte, sinon son envoi est toutefois interrompu.

6. Procédé selon la revendication 5, **caractérisé en ce que** l'envoi du signal de déclenchement (p, p₂) est interrompu quand aucun événement d'utilisation n'a été détecté de sorte que le signal de déclenchement (p, p₂) reste incomplet et l'opération ayant lieu avant l'ajustement de l'élément de fermeture de véhicule (H) n'est pas déclenchée.

7. Procédé selon l'une quelconque des revendications précédentes, **caractérisé en ce que** le dépassement ou le non-dépassement d'une valeur de seuil (s₁, s₂) spécifiée déclenche le début de l'envoi du signal de déclenchement (p, p₁, p₂) avant que le laps de temps de détection (Δt₁) ne soit écoulé et il est évalué si un événement d'utilisation est présent ou non.

8. Procédé selon l'une quelconque des revendications précédentes, **caractérisé en ce qu'**un entraînement (HM) est activé au moyen d'un signal de commande (p₂) pour l'ajustement de l'élément de fermeture de véhicule (H), dans lequel l'envoi du signal de commande (p₂) a commencé après que le laps de temps de détection (Δt₁) s'est écoulé et il est évalué si un événement d'utilisation est présent ou non.

9. Procédé selon l'une quelconque des revendications précédentes, **caractérisé en ce qu'**un mouvement de coup de pied exécuté par une personne peut être détecté sans contact en tant qu'événement d'utilisation au moyen du dispositif de capteur (1A, 1B).

10. Procédé selon l'une quelconque des revendications précédentes, **caractérisé en ce que** la génération et le début de l'envoi du signal de déclenchement (p, p₁, p₂) dépendent d'au moins un critère supplémentaire.

11. Procédé selon l'une quelconque des revendications précédentes, **caractérisé en ce que** l'au moins un critère supplémentaire est une progression dans le temps de valeurs de mesure détectées les unes après les autres et/ou la valeur d'un maximum de valeurs de mesure détectées.

12. Système de commande pour un dispositif d'ajustement pour ajuster par l'actionnement d'une force extérieure un élément de fermeture de véhicule, par l'intermédiaire duquel une ouverture de carrosserie d'un véhicule peut être fermée et qui peut être ajusté automatiquement en présence d'un événement d'utilisation pour dégager l'ouverture de carrosserie, avec :
- un dispositif de capteur (1A, 1B), au moyen duquel il peut être détecté sans contact en tant qu'événement d'utilisation qu'une personne exécute avec une partie corporelle (F) un mouvement défini dans une zone de détection (10A, 10B), et
- un dispositif de commande électronique (SE), au moyen duquel
∘ - une évolution de valeurs de mesure détectées par le dispositif de capteur (1A, 1B) dans un laps de temps de détection (Δt₁) peut être évaluée pour savoir si un événement d'utilisation est présent ou non, et
∘ - au moins un signal de déclenchement (p, p₁, p₂) d'une longueur de signal définie (t_{E} - peut être généré et envoyé, qui déclenche au moins une opération ayant lieu avant l'ajustement de l'élément de fermeture de véhicule (H),
**caractérisé en ce que**
le dispositif de commande électronique (SE) est configuré
a) pour utiliser au moins une valeur de mesure détectée pour la présence d'un événement d'utilisation, pour déclencher l'envoi d'un signal de déclenchement (p, p₁) pour un processus d'authentification, dans lequel la présence d'un moyen d'identification (T) valable est vérifiée dans un environnement du véhicule (FZ), avant que le laps de temps de détection (Δt₁) ne soit écoulé et l'évolution des valeurs de mesure peut être évaluée pour savoir si un événement d'utilisation est présent ou non, dans lequel l'envoi du signal de déclenchement (p, p₁) est déclenché à un moment (tₛ) dans le laps de temps de détection (Δt₁), auquel un critère enregistré dans un dispositif de commande électronique (SE) concernant le nombre de valeurs de mesure détectées est rempli, et/ou
b) pour débuter à un moment (t_{P}) dans le laps de temps de détection (Δt₁) l'envoi du signal de déclenchement (p, p₂) de sorte qu'à l'issue du laps de temps de détection (Δt₁), le signal de déclenchement (p, p₂) n'a pas encore atteint la longueur de signal définie (t_{E} - t_{P}) et le signal de déclenchement (p, p₂) est envoyé seulement en cas de détection d'un événement d'utilisation jusqu'à ce que la longueur de signal définie (t_{E} - tₚ) soit atteinte, sinon son envoi est toutefois interrompu.
